# EUROPÄISCHE PATENTSCHRIFT

(11) **EP 4 457 846 B1**
(45) Veröffentlichungstag und Bekanntmachung des Hinweises auf die Patenterteilung: **19.11.2025**
(21) Anmeldenummer: 23709678.9
(22) Anmeldetag: 06.03.2023
(51) Int. Cl.: H01H 9/00

(54) **ZUSTANDSANALYSE EINES LASTSTUFENSCHALTERS**
STATE ANALYSIS OF AN ON-LOAD TAP CHANGER
ANALYSE D'ÉTAT D'UN CHANGEUR DE PRISES EN CHARGE

(30) Priorität: 23.03.2022 DE 102022106774
(43) Veröffentlichungstag der Anmeldung: 06.11.2024
(73) Patentinhaber: Maschinenfabrik Reinhausen GmbH, 93059 Regensburg (DE)
(72) Erfinder: REHKOPF, Sebastian, 93059 Regensburg (DE); ZINTL, Markus, 95666 Mitterteich (DE); DOLLES, Markus, 93055 Regensburg (DE); GLASER, Beate, 85283 Wolnzach (DE)
(86) Internationale Anmeldenummer: PCT/EP2023/055574
(87) Internationale Veröffentlichungsnummer: WO 2023/180052

(56) Entgegenhaltungen:
- EP-A1- 2 541 572
- EP-A1- 3 745 434
- WO-A1-2011/085763
- US-A- 3 925 722

## Beschreibung

Die Erfindung betrifft ein Verfahren zur Zustandsanalyse eines Laststufenschalters sowie eine Vorrichtung zur Zustandsanalyse eines Laststufenschalters.

Laststufenschalter werden zur unterbrechungslosen Umschaltung zwischen Wicklungsanzapfungen eines Transformators eingesetzt und stellen demnach ein wesentliches Betriebsmittel für Transformatoren dar, auf deren Zuverlässigkeit besonderes Augenmerk liegt. Solche Laststufenschalter bestehen üblicherweise aus einem Wähler zur leistungslosen Anwahl der jeweiligen Wicklungsanzapfung des Transformators, auf die umgeschaltet werden soll, und einem Lastumschalter zur eigentlichen Umschaltung von der bisherigen auf die neue, vorgewählte Wicklungsanzapfung. Der Lastumschalter weist dazu üblicherweise Vakuumschaltröhren und Überschaltwiderstände auf. Die Vakuumschaltröhren dienen dabei zur Verbindung der jeweiligen Wicklungsanzapfung mit der Lastableitung, die Überschaltwiderstände zur kurzzeitigen Strombegrenzung während der Umschaltung. Eine Vakuumschaltröhre weist üblicherweise Schaltkontakte aus einer lichtbogenresistenten Kupfer-Wolfram-Legierung auf. Beim Betätigen der Vakuumschaltröhre entstehen regelmäßig Lichtbögen, die geringe Mengen des Kontaktmaterials abschmelzen bzw. verdampfen und so zu einem Kontaktabbrand oder auch zu Unregelmäßigkeiten in der Kontaktoberfläche führen können. Des Weiteren kann es infolge des verdampften Materials zu einer Bedampfung der Isolationsstrecken im Inneren der Vakuumschaltröhre kommen, welche eine Verminderung der Isolationsfestigkeit der Vakuumschaltröhre zur Folge haben kann.

Diese Vorgänge beeinflussen folglich auch die Lebensdauer einer Vakuumschaltröhre und des Laststufenschalters, in der sie zum Einsatz kommt.

Die maximale Lebensdauer von Laststufenschaltern und den darin befindlichen Vakuumschaltröhren wird üblicherweise durch Versuche unter Worst-Case-Bedingungen ermittelt. Zur Sicherstellung eines zuverlässigen Betriebs des Laststufenschalters muss basierend auf den Ergebnissen der durchgeführten Versuche ein Sicherheitspuffer an Umschaltvorgängen des Laststufenschalters eingehalten, und der Laststufenschalter gegebenenfalls früher gewartet oder ausgetauscht werden.

Im realen Betrieb sind die Belastungen, die ein Laststufenschalter erfährt, in der Regel jedoch deutlich geringer. Das Dokument EP3745434 bezieht sich auf ein Verfahren und ein Uberwachungssystem, bei dem Parameter gemessen werden, um den Betriebszustand eines Laststufenschalters mit Vakuumschaltern zu bewerten.

Es ist daher Aufgabe der vorliegenden Erfindung ein verbessertes Konzept für eine Zustandsanalyse eines Laststufenschalters anzugeben, welches die tatsächliche Belastung des Laststufenschalters erfasst und eine genauere Bewertung des Zustands des Laststufenschalters ermöglicht.

Diese Aufgabe wird durch den jeweiligen Gegenstand der unabhängigen Ansprüche gelöst. Weitere Ausführungsformen sind Gegenstand der abhängigen Ansprüche.

Gemäß einem ersten Aspekt des verbesserten Konzepts wird ein Verfahren zur Zustandsanalyse eines Laststufenschalters gemäß Anspruch 1 angegeben.

Der Vorteil des beschriebenen Verfahrens gegenüber dem Stand der Technik besteht darin, dass durch die Erfassung der Echtzeitdaten unter Berücksichtigung der stufenschalterspezifischen Parameter der ermittelte, wenigstens eine Kennwert die tatsächliche Belastung wiedergibt, die der Laststufenschalter erfahren hat. Die Kenntnis des tatsächlichen Zustands des Laststufenschalters ermöglicht die Optimierung der Wartungsintervalle sowie der Nutzung des Laststufenschalters im Allgemeinen und eine erhöhte Lebensdauer. Zudem kann durch die Erfassung der tatsächlichen Belastung das Eintreten von kritischen Zuständen des Laststufenschalters frühzeitig erkannt und vermieden werden.

Gemäß einer bevorzugten Ausführungsform umfasst das Erfassen von Echtzeitdaten ein Ermitteln des Laststromes bei jeder Umschaltung oder ein Ermitteln der Stufenspannung bei jeder Umschaltung oder ein Ermitteln der aktuellen Stellung des Laststufenschalters oder ein Ermitteln der Schaltrichtung einer bevorstehenden Umschaltung, d. h. ermitteln, ob das Übersetzungsverhältnis des Transformators vergrößert oder verkleinert wird, oder ein Ermitteln einer Temperatur eines Isoliermittels, in dem sich die Vakuumschaltröhre befindet, oder ein Ermitteln der Schalthäufigkeit in einem festgelegten Zeitraum oder ein Ermitteln der Dauer einer Umschaltung oder ein Ermitteln einer Lichtbogenbrenndauer bei jeder Umschaltung.

Des Weiteren können beispielsweise die Dauer und Höhe eines während des Umschaltvorganges durch den Laststufenschalter fließenden Kreisstroms oder weitere Temperaturen, zum Beispiel die Temperatur an den Vakuumschaltröhren oder den Überschaltwiderständen des Laststufenschalters, ermittelt werden.

Unter dem Begriff Ermitteln wird hierbei die Erfassung von Daten, beispielsweise durch Messung mittels geeigneter Sensoren, sowie die Weiterverarbeitung von Daten, beispielsweise in Form von Berechnungen basierend auf den erfassten Daten zur Ermittlung weiterer relevanter Kenngrößen, verstanden.

Gemäß einer Ausführungsform umfassen die stufenschalterspezifischen Daten die Anzahl und Dimensionierung der Überschaltwiderstände, die Schaltungstopologie des Laststufenschalters, insbesondere die Verschaltung der Vakuumschaltröhren zueinander, oder die Anzahl und Dimensionierung der Vakuumschaltröhren.

Gemäß der Erfindung umfassen die stufenschalterspezifischen Daten insbesondere spezifische Daten der wenigstens einen Vakuumschaltröhre.

Spezifische Daten der Vakuumschaltröhre umfassen charakteristische Parameter der Vakuumschaltröhre wie das Kontaktmaterial, die Geometrie der Röhre oder durch Versuche ermittelte Grenzwerte, wie beispielsweise Abbrandgrenzwerte, die durchschnittliche Lichtbogenbrenndauer oder die durchschnittliche Lichtbogenenergie.

Gemäß einer bevorzugten Ausführungsform umfasst der wenigstens eine Kennwert einen Kontaktabbrand.

Der Kontaktabbrand bezieht sich auf den Abbrand von Kontaktmaterial der Schaltkontakte der Vakuumschaltröhre in Folge der Entstehung von Lichtbögen. Bevorzugt wird der Kontaktabbrand in Volumeneinheiten erfasst.

Gemäß einer weiteren Ausführungsform werden zusätzlich zu dem Kontaktabbrand eine Verminderung der Isolationsfestigkeit der Vakuumschaltröhre und/oder Unregelmäßigkeiten auf der Kontaktoberfläche als Kennwerte ermittelt.

Durch den Lichtbogen, der gewöhnlich im ersten Nulldurchgang des Stromes erlischt, verdampft Kontaktmaterial und ein Metalldampf entsteht, der sich in der Vakuumschaltröhre ausbreitet und entsprechend kondensiert und dadurch die Isolationsfestigkeit der Vakuumschaltröhre beeinträchtigten kann.

Zudem kann das Abschmelzen bzw. Verdampfen von Kontaktmaterial zur Entstehung von Unregelmäßigkeiten in der Kontaktoberfläche beitragen, die wiederum die Lichtbogenlöschung im Nulldurchgang beeinträtchtigen können, indem beispielsweise Rückzündungen auftreten.

Gemäß einer weiteren Ausführungsform umfasst der wenigstens eine Kennwert einen Zustand des Vakuums innerhalb der Vakuumschaltröhre.

Gemäß einer weiteren Ausführungsform wird der wenigstens eine Kennwert mit einem festgelegten Grenzwert verglichen und im Falle einer Überschreitung des Grenzwertes eine Meldung ausgegeben.

Als Grenzwert kann beispielsweise ein bestimmtes Volumen an verdampftem Kontaktmaterial oder die Dicke einer Metalldampfschicht, die sich im Inneren der Vakuumschaltröhre auf der Isolierstrecke infolge der Lichtbogenlöschung ablagert, festgelegt werden. Ebenso kann eine bestimmte Anzahl an Unregelmäßigkeiten auf der Kontaktoberfläche als Grenzwert herangezogen werden.

Gemäß einer weiteren Ausführungsform umfasst das Verfahren den folgenden, weiteren Schritt:
- Ermitteln der im Laststufenschalter und der Vakuumschaltröhre vorliegenden Betriebsbedingungen basierend auf den Echtzeitdaten und den stufenschalterspezifischen Parametern.

Bei der Ermittlung der Betriebsbedingungen wird die Anwendung, in der der Laststufenschalter betrieben wird, mit anderen Worten der Einsatzort des Transformators, in die Zustandsanalyse mit einbezogen. Denn je nachdem, wie häufig der Laststufenschalter betätigt wird, welche Dauer und Höhe ein dabei in dem Laststufenschalter fließender Kreisstrom aufweist, wie hoch dementsprechend die Kontakterwärmung ist und für welche Leistungsklasse der Laststufenschalter ausgebildet ist, kann sich der Einfluss auf den Zustand unterschiedlich auswirken.

Beispielsweise werden bei Laststufenschaltern, die in Transformatoren in Lichtbogenöfen zum Einsatz kommen, eine gewisse Anzahl an Leerschaltungen durchgeführt, bei welchen der Laststufenschalter zwar betätigt wird, jedoch kein Strom geschalten wird. Dabei erfährt der Laststufenschalter lediglich eine mechanische Beanspruchung, die in der Regel weniger Einfluss auf den Zustandsindex ausübt wie ein Schaltvorgang, bei dem Strom fließt und ein Lichtbogen gelöscht wird.

Gemäß einer weiteren Ausführungsform erfolgt das Ermitteln des wenigstens einen Kennwertes basierend auf Modellsimulation oder maschinellen Lernverfahren und/oder Interpolationsverfahren und/oder historischen Daten.

Beispielsweise können bei der Modellsimulation geeignete Elektrohydrodynamikmodelle oder Modelle zur Partikelausbreitung oder Lichtbogenbildung zum Einsatz kommen. Gleichermaßen können mechanische Belastungen, beispielsweise die Belastung auf den Balg einer Vakuumschaltröhre, und elektrische Schaltungen mit geeigneter Software simuliert werden.

Zum Ermitteln des Kennwertes kann beispielsweise ein künstliches neuronales Netz als Methodik im Bereich des maschinellen Lernens herangezogen werden. Ebenso möglich ist die Anwendung eines Regressionsalgorithmus oder anderer, bekannter maschineller Lernverfahren.

Im Falle der Betrachtung historischer Daten werden beispielsweise Ergebnisse aus durchgeführten Versuchen mit vergleichbaren Daten und Parametern oder Rückschlüsse aus Felderfahrungsgeräten herangezogen. Auch eine übergeordnete Datenbank, beispielsweise eine Cloud, die Daten einer ganzen Transformatorflotte umfasst, kann als Datenquelle für historische Daten dienen.

Gemäß einem zweiten Aspekt des verbesserten Konzepts wird eine Vorrichtung zur Zustandsanalyse eines Laststufenschalters gemäß Anspruch 6 angegeben.

Bezüglich der Vorrichtung wird auf die vorangegangenen Erläuterungen, bevorzugten Merkmale, Effekte und/oder Vorteile, wie sie für das Verfahren bereits erläutert worden sind, in analoger Weise Bezug genommen. Auf eine entsprechende Wiederholung wird deshalb verzichtet.

Als übergeordnetes Steuerungssystem kann beispielsweise eine Leitstelle eines Energieversorgungsunternehmens fungieren.

Gemäß einer Ausführungsform umfasst die Vorrichtung außerdem eine Ausgabeeinheit zur Ausgabe eines Zustandsindex des Laststufenschalters. Die Ausgabeeinheit kann weiterhin dazu ausgebildet sein, in Abhängigkeit von dem Zustandsindex eine Handlungsempfehlung oder Warnmeldung auszugeben.

Hierfür kann die Ausgabeeinheit entsprechend geeignete Mittel zur Visualisierung aufweisen, beispielsweise einen Bildschirm oder LED-Leuchtmittel, die zum Beispiel einen kritischen Zustand signalisieren.

Gemäß einer weiteren Ausführungsform weisen der Laststufenschalter und der Transformator für die Erfassung der Echtzeitdaten geeignete Sensoren auf, wie zum Beispiel einen Stromsensor auf der Primär- und/oder Sekundärseite des Transformators oder einen Temperatursensor in dem Isoliermittel des Laststufenschalters.

Im Folgenden wird die Erfindung anhand beispielhafter Ausführungsformen unter Bezug auf die Zeichnungen im Detail erklärt. Komponenten, die identisch oder funktionell identisch sind oder einen identischen Effekt haben, können mit identischen Bezugszeichen versehen sein. Identische Komponenten oder Komponenten mit identischer Funktion sind unter Umständen nur bezüglich der Figur erklärt, in der sie zuerst erscheinen. Die Erklärung wird nicht notwendigerweise in den darauffolgenden Figuren wiederholt.

Es zeigen
- Figur 1: eine vorteilhafte Ausführungsform einer Vorrichtung gemäß dem verbesserten Konzept,
- Figur 2: eine vorteilhafte Ausführungsform eines Verfahrens gemäß dem verbesserten Konzept.

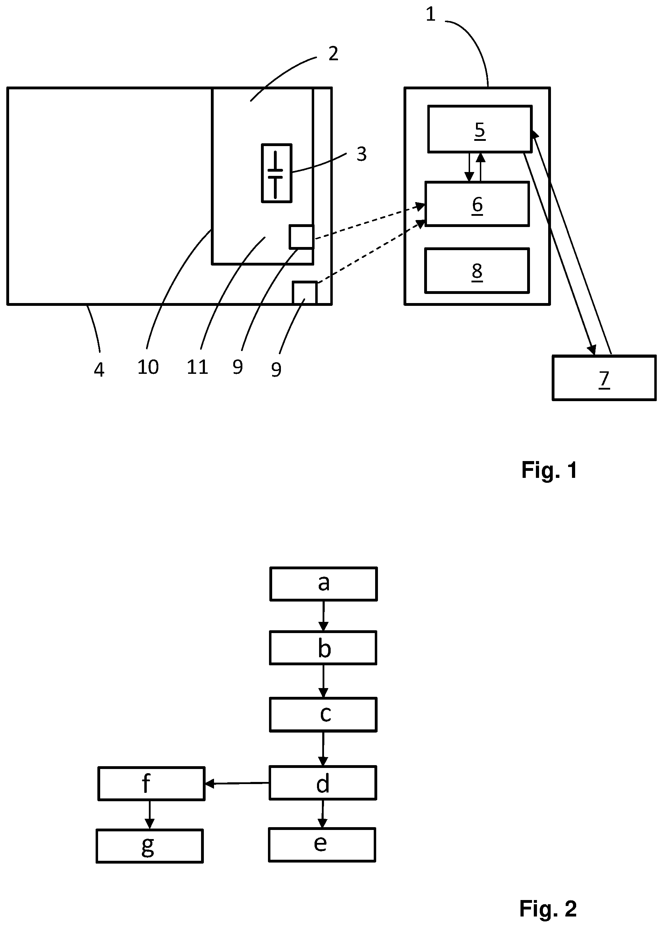

In Figur 1 ist eine vorteilhafte Ausführungsform einer Vorrichtung 1 gemäß dem verbesserten Konzept in einer schematischen Darstellung gezeigt.

Die Vorrichtung 1 dient zur Zustandsanalyse eines Laststufenschalters 2, der eine Vakuumschaltröhre 3 zur Umschaltung zwischen Wicklungsanzapfungen (nicht dargestellt) eines Transformators 4 aufweist. Die Vakuumschaltröhre 3 befindet sich in einem Gehäuse 10 des Laststufenschalters 2, welches zumindest teilweise mit Isoliermittel 10 gefüllt ist. Grundsätzlich kann der Stufenschalter 2 mitsamt Vakuumschaltröhre 3 jedoch auch ohne Gehäuse im Transformator 4 angeordnet sein, sodass sich der Stufenschalter 2 im Ölhaushalt des Transformators 4 befindet. In Figur 1 ist beispielhaft und zur besseren Übersicht nur eine Vakuumschaltröhre abgebildet. In der Regel weist der Laststufenschalter 2 jedoch mehrere Vakuumschaltöhren 3 zur Umschaltung auf.

Die Vorrichtung 1 umfasst eine Auswerteeinheit 5, einen Datenspeicher 6 und eine Ausgabeeinheit 8. In dem Datenspeicher 6 sind für die Durchführung der Zustandsanalyse relevante Daten abgelegt, wie Echtzeitdaten in Bezug auf den Laststufenschalter 2, spezifische Paramater des Laststufenschalters 2 und der Vakuumschaltröhre 3, Grenzwerte relevanter Kennwerte oder historische Daten, die für die Ermittlung des Zustands des Laststufenschalters 2 und der Vakuumschaltröhre 3 herangezogen werden. Für die Erfassung der Echtzeitdaten weisen der Laststufenschalter 2 und der Transformator 4 jeweils einen Sensor 9 auf. Gemäß der in Fig. 1 gezeigten Ausführungsform weist der Stufenschalter 2 beispielsweise einen Temperatursensor 9 zur Messung der Temperatur des Isoliermittels 11 auf und der Transformator 4 beispielsweise einen Stromsensor 9 auf der Primär- und/oder Sekundärseite. Grundsätzlich können jedoch noch weitere Sensoren 9 für die Erfassung der Echtzeitdaten vorgesehen sein.

Die Auswerteeinheit 5 ist kommunikativ mit dem Datenspeicher 6 verbunden und dazu ausgebildet, die Echtzeitdaten und stufenschalter- sowie vakuumschaltröhrenspezifischen Parameter zu erhalten und basierend darauf wenigstens einen Kennwert zur Bestimmung eines Zustandsindex des Laststufenschalters 2 zu ermitteln. Zusätzlich zu dem Datenspeicher 6 ist die Auswerteeinheit 5 gemäß dieser Ausführungsform mit einem übergeordneten Steuerungssystem 7, beispielsweise der Leitstelle eines Energieversorgungsunternehmens, kommunikativ verbunden und kann über diese Verbindung weitere Daten zur Ermittlung des Kennwertes beziehen. Die Ermittlung des Kennwertes erfolgt basierend auf Modellsimulation, maschineller Lernverfahren, Interpolationsverfahren, historischen Daten oder Kombinationen hiervon.

Die erläuterten Funktionalitäten der Auswerteeinheit 5 können durch Hardware, Firmware, Software, sonstige maschinenlesbare Befehlscodes oder einer Kombination davon implementiert werden.

Der Zustandsindex wird über die Ausgabeeinheit 8 ausgegeben. Hierfür weist die Ausgabeeinheit 8 entsprechende Mittel zur Visualisierung auf, wie zum Beispiel einen Bildschirm.

In Figur 2 ist eine vorteilhafte Ausführungsform eines Verfahrens gemäß dem verbesserten Konzept in Form eines Ablaufdiagramms dargestellt.

Bezüglich des Verfahrens wird auf die vorangegangenen Erläuterungen, bevorzugten Merkmale, Effekte und/oder Vorteile, wie sie für die Vorrichtung 1 bezüglich Figur 1 bereits erläutert worden sind, in analoger Weise Bezug genommen. Auf eine entsprechende Wiederholung wird deshalb verzichtet.

Die vorteilhafte Ausführungsform des Verfahrens dient zur Zustandsanalyse eines Laststufenschalters, der wenigstens eine Vakuumschaltröhre zur Umschaltung zwischen Wicklungsanzapfungen eines Transformators aufweist. Bevorzugt dient das Verfahren zur Zustandsanalyse eines Laststufenschalters 2 in einem Transformator 4 mit einer Vorrichtung 1, wie in Figur 1 dargestellt.

In einem Schritt a werden Echtzeitdaten in Bezug auf den Laststufenschalter 2 mittels geeigneter Sensoren 9 erfasst. Echtzeitdaten sind beispielsweise der bei jeder Umschaltung fließende Laststrom oder die anliegende Stufenspannung, die aktuelle Stellung n des Laststufenschalters, die Schaltrichtung einer bevorstehenden Umschaltung, die Temperatur des die Vakuumschaltröhre umgebenden Isoliermittels, die Schalthäufigkeit in einem festgelegten Zeitraum, die Dauer einer Umschaltung oder die Lichtbogenbrenndauer bei jeder Umschaltung.

In einem Schritt b werden stufenschalterspezifische Parameter, wie zum Beispiel die Anzahl und Dimensionierung der Überschaltwiderstände, die Schaltungstopologie des Laststufenschalters, insbesondere die Verschaltung der Vakuumschaltröhren zueinander, oder die Anzahl und Dimensionierung der Vakuumschaltröhren, sowie spezifische Daten der Vakuumschaltröhren ermittelt. Spezifische Daten einer Vakuumschaltröhre umfassen charakteristische Parameter wie das Kontaktmaterial, die Geometrie der Röhre und die Kinematik der Röhrenbetätigung oder durch Versuche ermittelte Grenzwerte, wie beispielsweise Abbrandgrenzwerte, die durchschnittliche Lichtbogenbrenndauer oder die durchschnittliche Lichtbogenenergie. Ebenso können Öffnungs- und Schließgeschwindigkeiten der Röhre und der Innendruck der Vakuumschaltröhre als spezifische Parameter der Vakuumschaltröhre berücksichtigt werden.

In einem Schritt c werden die im Laststufenschalter 2 und der Vakuumschaltröhre 3 vorliegenden Betriebsbedingungen, beispielsweise die Schalthäufigkeit, Dauer und Höhe des bei der Betätigung fließenden Kreisstroms oder die Kontakterwärmung, basierend auf den Echtzeitdaten, den stufenschalterspezifischen Parametern und den spezifischen Daten der Vakuumschaltröhre 3 ermittelt.

Die Ausführung der Schritte a, b und c ist nicht auf die in dem Ablaufdiagramm in Figur 2 gezeigte Reihenfolge beschränkt. Die Schritte a, b und c können hingegen auch in umgekehrter und/oder vertauschter Reihenfolge zueinander oder zeitgleich ausgeführt werden.

In einem Schritt d wird wenigstens ein Kennwert zur Bestimmung eines Zustandsindex des Laststufenschalters 2 basierend auf den Echtzeitdaten, den stufenschalterspezifischen Parametern und den spezifischen Daten der Vakuumschaltröhre 3 ermittelt. Der Zustandsindex umfasst dabei einen Zeitraum bis zu einer fälligen Wartung und/oder eine verbleibende Lebensdauer und/oder eine verbleibende Anzahl an Umschaltungen des Laststufenschalters 2.

Der wenigstens eine Kennwert zur Bestimmung des Zustandsindex ist gemäß dieser Ausführungsform als Kontaktabbrand ausgebildet. Grundsätzlich ist das erfindungsgemäße Verfahren jedoch nicht auf diesen Kennwert beschränkt. Es können hingegen auch noch weitere Kennwerte, wie eine Verminderung der Isolationsfestigkeit der Vakuumschaltröhre bedingt durch Metalldampf oder Unregelmäßigkeiten auf der Kontaktoberfläche als Kennwerte ermittelt werden.

Die Ermittlung des Kennwertes und der gegebenenfalls weiteren Kennwerte erfolgt basierend auf Modellsimulation, maschineller Lernverfahren, Interpolationsverfahren, historischer Daten oder Kombinationen hiervon.

In einem Schritt e erfolgt die Ausgabe des Zustandsindex mittels der Ausgabeeinheit 8.

Unabhängig von der Ausgabe des Zustandsindex wird gemäß dieser konkreten Ausführungsform in einem Schritt f der ermittelte Kennwert mit einem festgelegten Grenzwert verglichen und im Falle einer Überschreitung des Grenzwertes in Schritt g eine zusätzliche Warnmeldung mittels der Ausgabeeinheit 8 ausgegeben.

### BEZUGSZEICHEN

- 1: Vorrichtung
- 2: Laststufenschalter
- 3: Vakuumschaltröhre
- 4: Transformator
- 5: Auswerteeinheit
- 6: Datenspeicher
- 7: übergeordnetes Steuerungssystem
- 8: Ausgabeeinheit
- 9: Sensor
- 10: Gehäuse
- 11: Isoliermittel

## Patentansprüche

1. Verfahren zur Zustandsanalyse eines Laststufenschalters (2), wobei der Laststufenschalter (2) wenigstens eine Vakuumschaltröhre (3) zur Umschaltung zwischen Wicklungsanzapfungen eines Transformators (4) aufweist, und das Verfahren die folgenden Schritte umfasst:
- Erfassen von Echtzeitdaten in Bezug auf den Laststufenschalter (2),
- Ermitteln von stufenschalterspezifischen Parametern,
- Ermitteln der im Laststufenschalter (2) und der Vakuumschaltröhre (3) vorliegenden Betriebsbedingungen basierend auf den Echtzeitdaten und den stufenschalterspezifischen Parametern,
- Ermitteln wenigstens eines Kennwertes zur Bestimmung eines Zustandsindex des Laststufenschalters (2) basierend auf den Echtzeitdaten und den stufenschalterspezifischen Parametern,
wobei
- die stufenschalterspezifischen Parameter spezifische Daten der wenigstens einen Vakuumschaltröhre (3) umfassen, die charakteristische Parameter der Vakuumschaltröhre (3) wie das Kontaktmaterial, die Geometrie der Röhre oder durch Versuche ermittelte Grenzwerte umfassen,
- der Zustandsindex einen Zeitraum bis zu einer fälligen Wartung oder eine verbleibende Lebensdauer oder eine verbleibende Anzahl an Umschaltungen des Laststufenschalters (2) umfasst.

2. Verfahren nach dem vorherigen Anspruch 2, wobei das Erfassen von Echtzeitdaten umfasst:
- ein Ermitteln des Laststromes bei jeder Umschaltung, oder
- ein Ermitteln der Stufenspannung bei jeder Umschaltung, oder
- ein Ermitteln der aktuellen Stellung n des Laststufenschalters (2), oder
- ein Ermitteln der Schaltrichtung einer bevorstehenden Umschaltung, oder
- ein Ermitteln einer Temperatur eines Isoliermittels (11), in dem sich die Vakuumschaltröhre (3) befindet, oder
- ein Ermitteln der Schalthäufigkeit in einem festgelegten Zeitraum, oder
- ein Ermitteln der Dauer einer Umschaltung, oder
- ein Ermitteln einer Lichtbogenbrenndauer bei jeder Umschaltung.

3. Verfahren nach einem der vorherigen Ansprüche 1 bis 3, wobei
- der wenigstens eine Kennwert einen Kontaktabbrand oder eine Verminderung der Isolationsfestigkeit der Vakuumschaltröhre (3) oder Unregelmäßigkeiten auf der Kontaktoberfläche umfasst.

4. Verfahren nach einem der vorherigen Ansprüche 1 bis 4, wobei
- der wenigstens eine Kennwert mit einem festgelegten Grenzwert verglichen wird,
- im Falle einer Überschreitung des Grenzwertes eine Meldung ausgegeben wird.

5. Verfahren nach einem der vorherigen Ansprüche 1 bis 5, wobei
- das Ermitteln des wenigstens einen Kennwertes basierend auf Modellsimulation oder maschinellen Lernverfahren oder Interpolationsverfahren oder historischen Daten erfolgt.

6. Vorrichtung (1) zur Zustandsanalyse eines Laststufenschalters (2), wobei der Laststufenschalter (2) wenigstens eine Vakuumschaltröhre (3) zur Umschaltung zwischen Wicklungsanzapfungen eines Transformators (4) aufweist, und wobei die Vorrichtung (1) umfasst:
- eine Auswerteeinheit (5) und
- einen Datenspeicher (6),
wobei
- in dem Datenspeicher (6) Echtzeitdaten in Bezug auf den Laststufenschalter (2) und stufenschalterspezifische Parameter ablegbar sind,
- die Auswerteeinheit (5) kommunikativ mit dem Datenspeicher (6) und/oder mit einem übergeordneten Steuerungssystem (7) verbunden und dazu ausgebildet ist, ein Verfahren gemäß der Ansprüche 1 bis 6 auszuführen.

7. Vorrichtung nach dem vorherigen Anspruch 7, weiterhin umfassend
- eine Ausgabeeinheit (8) zur Ausgabe eines Zustandsindex des Laststufenschalters (2).

8. Vorrichtung nach dem vorherigen Ansprüche 7 oder 8, wobei
- der Laststufenschalter (2) und der Transformator (4) für die Erfassung der Echtzeitdaten geeignete Sensoren (9) aufweisen.

## Claims

1. A method for analyzing the state of an on-load tap-changer (2), the on-load tap-changer (2) having at least one vacuum interrupter (3) for switching between winding taps of a transformer (4), the method comprising the following steps :
- Acquiring real-time data relating to the on-load tap-changer (2),
- determining parameters specific to the on-load tap-changer,
- determining the operating conditions present in the on-load tap-changer (2) and the vacuum interrupter (3) based on the real-time data and the tap-changer-specific parameters,
- determining at least one characteristic value for determining a state index of the on-load tap-changer (2) based on the real-time data and the tap-changer-specific parameters,
wherein
- the tap-changer-specific parameters comprise specific data of the at least one vacuum interrupter (3), which comprise characteristic parameters of the vacuum interrupter (3) such as the contact material, the geometry of the tube or limit values determined by tests,
- the condition index comprises a period until maintenance is due or a remaining service life or a remaining number of changeovers of the on-load tap-changer (2).

2. The method according to the previous claim 2, wherein the acquiring of real-time data comprises
- a determination of the load current at each changeover, or
- determining the tap-change voltage at each changeover, or
- determining the current position n of the on-load tap-changer (2), or
- determining the switching direction of an imminent changeover, or
- determining the temperature of an insulating medium (11) in which the vacuum interrupter (3) is located, or
- determining the switching frequency in a defined period of time, or
- determining the duration of a changeover, or
- determining an arc burning time for each changeover.

3. Method according to one of the preceding claims 1 to 3, wherein
- the at least one characteristic value comprises a contact burn-off or a reduction of the insulation strength of the vacuum interrupter (3) or irregularities on the contact surface .

4. The method according to any one of the preceding claims 1 to 4, wherein
- the at least one characteristic value is compared with a defined limit value,
- if the limit value is exceeded, a message is output.

5. Method according to any one of the preceding claims 1 to 5, wherein
- the determination of the at least one characteristic value is based on model simulation or machine learning methods or interpolation methods or historical data .

6. Device (1) for analyzing the state of an on-load tap-changer (2), wherein the on-load tap-changer (2) has at least one vacuum interrupter (3) for switching between winding taps of a transformer (4), and wherein the device (1) comprises
- an evaluation unit (5) and
- a data memory (6),
wherein
- real-time data relating to the on-load tap-changer (2) and tap-changer-specific parameters can be stored in the data memory (6) ,
- the evaluation unit (5) is communicatively connected to the data memory (6) and/or to a higher-level control system (7) and is designed to carry out a method according to claims 1 to 6.

7. Device according to the previous claim 7, further comprising
- an output unit (8) for outputting a status index of the on-load tap-changer (2).

8. The device according to the preceding claims 7 or 8, wherein
- the on-load tap-changer (2) and the transformer (4) have sensors (9) suitable for acquiring the real-time data.

## Revendications

1. Procédé d'analyse de l'état d'un commutateur à gradins de charge (2), le commutateur à gradins de charge (2) comportant au moins un tube de commutation à vide (3) pour commuter entre les prises d'enroulement d'un transformateur (4), le procédé comprenant les étapes suivantes :
- la collecte de données en temps réel relatives au commutateur à gradins de charge (2),
- détermination de paramètres spécifiques au changeur de prises,
- détermination des conditions de fonctionnement présentes dans le commutateur à gradins de charge (2) et le tube interrupteur à vide (3) sur la base des données en temps réel et des paramètres spécifiques au commutateur à gradins,
- détermination d'au moins une valeur caractéristique pour déterminer un indice d'état du changeur de prises en charge (2) sur la base des données en temps réel et des paramètres spécifiques au changeur de prises,
où
- les paramètres spécifiques au commutateur de gradins comprennent des données spécifiques d'au moins un tube interrupteur à vide (3), qui comprennent des paramètres caractéristiques du tube interrupteur à vide (3) tels que le matériau de contact, la géométrie du tube ou des valeurs limites déterminées par des essais,
- l'indice d'état comprend une période jusqu'à une maintenance prévue ou une durée de vie restante ou un nombre restant de commutations du changeur de prises en charge (2).

2. Procédé selon la revendication 2 précédente, dans lequel la collecte de données en temps réel comprend :
- la détermination du courant de charge à chaque commutation, ou
- une détermination de la tension de gradation à chaque commutation, ou
- une détermination de la position actuelle n du commutateur à gradins de charge (2), ou
- la détermination du sens de commutation d'une commutation imminente, ou
- une détermination d'une température d'un isolant (11) dans lequel se trouve le tube de commutation à vide (3), ou
- déterminer la fréquence de commutation dans une période de temps définie, ou
- déterminer la durée d'une commutation, ou
- déterminer une durée d'arc électrique à chaque commutation.

3. Procédé selon l'une des revendications 1 à 3 précédentes, dans lequel
- la au moins une valeur caractéristique comprend une usure des contacts ou une diminution de la résistance d'isolation du tube de commutation à vide (3) ou des irrégularités sur la surface de contact .

4. Procédé selon l'une des revendications 1 à 4 précédentes, dans lequel
- la au moins une valeur caractéristique est comparée à une valeur limite définie,
- et, en cas de dépassement de la valeur limite, un message est émis.

5. Procédé selon l'une des revendications 1 à 5 précédentes, dans lequel
- la détermination de la au moins une valeur caractéristique est effectuée sur la base d'une simulation de modèle ou d'un procédé d'apprentissage automatique ou d'un procédé d'interpolation ou de données historiques .

6. Dispositif (1) pour l'analyse de l'état d'un commutateur à gradins de charge (2), le commutateur à gradins de charge (2) comportant au moins un tube de commutation à vide (3) pour la commutation entre les prises d'enroulement d'un transformateur (4), et le dispositif (1) comprenant :
- une unité d'évaluation (5) et
- une mémoire de données (6),
dans lequel
- la mémoire de données (6) pouvant stocker des données en temps réel relatives au commutateur à gradins de charge (2) et des paramètres spécifiques au commutateur à gradins ,
- l'unité d'évaluation (5) étant reliée de manière communicative à la mémoire de données (6) et/ou à un système de commande supérieur (7) et étant conçue pour exécuter un procédé selon les revendications 1 à 6.

7. Dispositif selon la revendication 7 précédente, comprenant en outre
- une unité de sortie (8) pour délivrer un indice d'état du commutateur de prise en charge (2).

8. Dispositif selon les revendications 7 ou 8 précédentes, dans lequel
- le commutateur de prise en charge (2) et le transformateur (4) comportent des capteurs (9) adaptés à la détection des données en temps réel.
